# EUROPÄISCHE PATENTSCHRIFT

(11) **EP 1 083 603 B1**
(45) Veröffentlichungstag und Bekanntmachung des Hinweises auf die Patenterteilung: **03.12.2003**
(21) Anmeldenummer: 00118296.3
(22) Anmeldetag: 06.09.2000
(51) Int. Cl.: H01L 25/065, H01L 23/485, H01L 25/07

(54) **Leistungshalbleiter-Modul**
Power semiconductor module
Module semi-conducteur de puissance

(30) Priorität: 08.09.1999 DE 19942770
(43) Veröffentlichungstag der Anmeldung: 14.03.2001
(73) Patentinhaber: IXYS Semiconductor GmbH, D-68623 Lampertheim (DE)
(72) Erfinder: Leuckel, Bernt, Dipl.-Ing., 69502 Hemsbach (Bergstrasse) (DE); Lindemann, Andreas, Dr.-Ing., 68623 Lampertheim (DE)
(74) Vertreter: Luderschmidt, Schüler & Partner GbR

(56) Entgegenhaltungen:
- DE-A- 3 643 288
- DE-A- 19 601 372
- PATENT ABSTRACTS OF JAPAN vol. 016, no. 130 (E-1184), 2. April 1992 (1992-04-02) -& JP 03 292764 A (OKUMA MACH WORKS LTD), 24. Dezember 1991 (1991-12-24)

## Beschreibung

Die Erfindung bezieht sich auf ein Leistungshalbleiter-Modul mit einer Grundplatte, auf der mindestens ein mit Leistungshalbleiter-Chips bestücktes Substrat angeordnet ist, das über Druckelemente an die Grundplatte andrückbar ist.

Bei der Herstellung von Leistungshalbleiter-Modulen ist es in der Regel erforderlich, die Leistungshalbleiter oder Leistungshalbleiter-Chips vom Grundoder Kühlkörper, der der Wärmeabfuhr dient, elektrisch zu isolieren; hierzu finden weithin keramische Isolatoren in Scheibenform mit metallisierter Oberfläche, z.B. Direct-Copper-Bonding (DCB)-Substrate, Anwendung, auf deren einer Oberfläche im wesentlichen die Leistungshalbleiter-Chips angeordnet sind, während die andere Oberfläche thermisch an den Kühlkörper angekoppelt wird. Die von leistungsstärkeren Anwendungen benötigten Stromtragfähigkeiten der Leistungsschalter werden normalerweise durch Parallelschaltung einzelner Leistungshalbleiter-Chips zu einem Leistungsschalter erreicht. Zusätzlich können mehrere Leistungsschalter in einem gemeinsamen Gehäuse untergebracht werden, was den Aufbau montagetechnisch durch Verminderung der Anzahl der Bauteile vereinfacht, wie beispielsweise angesichts einer dreiphasigen Brückenschaltung für dreiphasige Gleich- oder Wechselrichtung deutlich wird, die anstatt aus bis zu sechs steuerbaren und sechs nicht steuerbaren Leistungsschaltern in der Ausführung als Einzelbauelemente so aus lediglich einem einzigen Bauelement bestehen kann. Beispiele für Leistungshalbleitermodule sind vielfach bekannt, vgl. z.B. EP-A-0 265 833, EP 0 277 546B1.

Es sind verschiedene Methoden bekannt, solche Leistungshalbleiter-Module aufzubauen.

Bezüglich elektrischer Verbindung zu den Anschlüssen werden beispielsweise auf das DCB-Substrat aufgelötete leitende Verbinder, insbesondere Laschen, auf das DCB-Substrat aufgepreßte leitende Verbinder, insbesondere Druckkontakte, und in einem zusätzlichen Isolator, z.B. einem Gehäuserahmen, befindliche leitende Verbinder verwendet, zu denen die elektrische Verbindung beispielsweise durch Drahtbonden hergestellt wird, was eine diesem Prozeß vorausgehende Montage des Isolators voraussetzt.

Hinsichtlich der thermischen Ankopplung an das Kühlmedium - typischerweise über die Unterseite des Bauelements - bildet bei einem Modul mit DCB-Boden - vgl. DE35 21 572A1 - die nicht von den Chips belegte Oberfläche der DCB-Keramik die Unterseite des Bauelements. Die thermische Kopplung wird in der Regel durch Anpressen an einen typischerweise metallischen Kühlkörper hergestellt, dem von einem Kühlmedium, wie Luft oder Kühlflüssigkeit, Wärme entzogen wird, wobei die Grenzfläche zwischen DCB-Boden und Kühlkörper vorteilhafterweise mit einer Zwischenlage aus einem thermisch verbindenden Medium, z.B. Wärmeleitpaste, zu versehen ist.

Bei einem Modul mit Bodenplatte wird die nicht von den Chips belegte Oberfläche der DCB-Keramik mit einer in der Regel aus einem Metall oder Verbundwerkstoff bestehenden Bodenplatte thermisch gekoppelt; die Kopplung kann durch Anpressen - vgl. DE41 31 200C2, DE41 11 247C2 und DE 41 22 428C2 typischerweise wiederum unter Verwendung eines thermisch verbindenden Mediums, z.B. Wärmeleitpaste, durch Anlöten - vgl. DE43 38 107C1 - oder durch andere schlüssige Verbindungen, letztere insbesondere bei Bodenplatten aus Verbundwerkstoffen, hergestellt werden. Die Bodenplatte ihrerseits wird dann gekühlt, was beispielsweise geschehen kann durch Anpressen an einen Kühlkörper oder durch Anströmen mit einem Kühlmedium, wie Luft oder Kühlflüssigkeit, unter der Voraussetzung einer geeigneten geometrischen Gestaltung.

Dieser Stand der Technik ist mit einer Reihe von Nachteilen wie folgt behaftet:

Leistungshalbleiter-Module dienten ursprünglich, wie oben ausgeführt, der Erhöhung des Integrationsgrades leistungselektronischer Schaltungsanordnungen. Verfolgt man dieses Ziel weiter, so wird es erforderlich, Leistungselektronik zusammen mit peripheren Funktionen wie Ansteuerung, Zwischenkreiskondensatoren u.ä. in ein verbrauchernahes Steuergerät zu integrieren: Für einen Einzelradantrieb mit einem Drehstrommotor könnte ein solches Steuergerät beispielsweise in der Form an das Motorgehäuse angelehnt werden, das gleiche Kühlmedium wie der Motor nutzen und als elektrische Schnittstellen eine Gleichspannungs-Einspeisung sowie einen bidirektionalen Bus zur Informationsübertragung aufweisen. Leistungshalbleitermodule nach dem Stand der Technik in den beschriebenen Ausführungsformen widersetzen sich solcher höheren Integration insofern, als sie als abgeschlossene Einheiten mit eigenem Gehäuse ausgeführt sind, welche aufgrund von Anforderungen wie mechanischer Stabilität mehr Volumen einnimmt, als bei höherer Integration erforderlich wäre; diese Tatsache ist sowohl unter den Gesichtspunkten von Kosten und Raumökonomie wie auch hinsichtlich des elektrischen Verhaltens, u.a. beeinflußt durch parasitäre Zuleitungsinduktivitäten, von Nachteil; auch wird die Zugänglichkeit beispielsweise zu den im Leistungshalbleiter-Modul vorhandenen elektrischen Potentialen durch das Gehäuse erschwert, was einen nicht unerheblichen konstruktiven Aufwand zum Anschluß des Moduls erforderlich machen kann.

Die Zuverlässigkeit der elektrischen Verbindungen, insbesondere bei gelöteten Anschlüssen nach außen, kann durch thermische Ermüdung zu wünschen übrig lassen. Man bemüht sich, dieser Tatsache durch geeignete Gestaltung der Anschlüsse, z.B. mit Dehnungsbögen, oder spezielle Lötverfahren - vgl. z.B. DD 283 236A5 - entgegenzuwirken. Werden die elektrischen Verbindungen hingegen über Druckkontakte mit metallischen Federn hergestellt, so können diese unter durch die Verlustwärme der umgebenden Halbleiter- Chips entstehenden Hitzeeinwirkung weich, d. h. verstärkt plastisch verformbar werden, so daß der Andruck der Substrate nachlassen wird. Weiterhin weisen durch ihre Härte mechanisch günstigere metallische Legierungen oft einen höheren elektrischen Widerstand als auf gutes Leitungsverhalten optimierte Materialien auf. Kontaktfedern, die diese Nachteile vermeiden, sind durch ihre besondere stoffliche Zusammensetzung meist teuer, daher wenig wirtschaftlich einzusetzen. In jedem Falle besteht die Gefahr, daß die Enden der Kontaktfedern bzw. die diesen gegenüberliegenden Kontaktflächen durch Kratzbewegungen bei thermisch bedingter Arbeit des Aufbaus verschlissen werden.

Die Sicherstellung des Wärmeübergangs ist mit Schwierigkeiten verbunden, konstruktiv aufwendig und häufig nicht über die erforderliche Lebensdauer des Leistungshalbleiter-Moduls gewährleistet: Beschreibung von Schwachstellen sowie Lösungsvorschläge finden sich z.B. in DE39 40 933 - Nachbiegen der belöteten Bodenplatte -, DE43 38 107C1 - Formgebung für Bodenplatte -, DE19 707 514A1 - Einführung von Sollbiegestellen in die Bodenplatte - DE35 08 456A1 - Andrückvorrichtung für das Substrat mittels Justierschrauben und Zwischenstücken- oder DE4 131 200 C2 - Ausübung des Druckes durch Federelemente, was eine Justierung erforderlich machen kann.

Nach dem Stand der Technik im Druckkontakt-Verfahren aufgebaute Leistungshalbleiter-Module zeichnen sich häufig durch aufwendige Konstruktionen aus: So wird in DE4 131 200C2 ein Aufbau mit einem speziell gestalteten Brückenelement beschrieben. Man erkennt, daß eine solche Konstruktion auf spezielle Schaltungen zugeschnitten sein muß; Schaltungsänderungen führen zu Werkzeugkosten bei entsprechenden Lieferzeiten, was sich angesichts steigender Anforderungen an Preise und Lieferzeiten auch für neue applikationsspezifische Leistungshalbleiter-Module nachteilig auswirkt.

Aus der DE-A-36 43 288 ist eine Halbleiterbaueinheit bekannt, die über eine Grundplatte mit einem Substrat verfügt, das mit einem Halbleiterchip bestückt ist. Die Kontaktierung des Halbleiterchips erfolgt über leitfähige und flexible Stromanschlußelemente, die an einem äußeren Rahmen befestigt sind. Nachteilig ist, dass der Reduzierung der Abmessungen des Moduls aufgrund der Bauhöhe der federnd vorgespannten Anschlußelemente Grenzen gesetzt sind.

Die Aufgabe der Erfindung besteht darin, ein Leistungshalbleiter-Modul der eingangs genannten Art zu schaffen, dessen Aufbau anwendungsabhängig auf die wesentlichen Teile reduziert ist und dessen Integrierbarkeit in ein Peripheriegerät, beispielsweise ein Steuergerät, dennoch gefördert wird. Hierbei sollen größtmögliche Raumökonomie sowie optimale Zugänglichkeit der elektrischen Potentiale sowie thermische Beständigkeit der Anschlüsse gewährleistet sein. Darüber hinaus soll das zu schaffende Modul durch einfache Fertigungsprozesse und -teile wirtschaftlich herstellbar sein sowie durch Rückgriff auf Standardkomponenten noch zusätzlich höhere Flexibilität für anwendungsspezifische Anpassung bieten.

Diese Aufgabe ist gemäß der Erfindung dadurch gelöst, dass die Druckelemente elastische und leitfähige Kontaktschnüre aufweisen, welche zwischen Kontaktschienen und Substraten angeordnet sind, wobei die Kontaktschnüre einen elastischen Kern und eine elektrisch leitfähige Umhüllung aufweisen.

Die Kontaktschnüre werden durch Niederhalten relativ starker Druckelemente sowohl gegen diese als auch gegen die auf der gegenüberliegenden Seite der Kontaktschnüre angeordneten Metallisierungen der Substrate gedrückt. Auf diese Weise wird eine zuverlässige dauerstandfeste elektrische Verbindung zwischen den Metallisierungen der Substrate, mit denen die Halbleiter-Chips elektrisch verbunden sind, und den Druckelementen über die Kontaktschnüre erreicht; außerdem drücken die Kontaktschnüre die Substrate gegen die auf deren entgegengesetzter Seite befindliche Grundplatte, so dass ein günstiger Wärmeübergang zwischen den Substraten mit den zu kühlenden Halbleiter-Chips und der gekühlten Grundplatte erreicht wird.

Die erfindungsgemäße Anordnung und Weiterbildung der Kontaktschnüre schafft zugleich die Voraussetzung für eine vorteilhafte Ausbildung des Gesamtaufbaus des erfindungsgemäßen Leistungshalbleiter-Moduls in Richtung auf eine vergleichsweise einfache Fertigung, auch für unterschiedliche Anwendungs- und Einsatzgebiete. Sie ist dadurch gekennzeichnet, daß auf der Grundplatte ein Felder definierender Rahmen mittels Zentrierelementen fixierbar ist, wobei mindestens ein Teil der Felder korrespondierende Substrate, die mit Leistungshalbleiter-Chips bestückt sind, aufnimmt.

Diese erfindungsgemäße Ausbildung eines Leistungshalbleiter-Moduls gibt definierte Positionen für die Substrate mit den darauf befindlichen Halbleiter-Chips vor. In Anpassung an verschiedene Bedarfsfälle ist es möglich, sämtliche oder einzelne Felder mit Substraten zu belegen und anschließend zu kontaktieren. Einer Änderung der Werkzeuge für die Herstellung des Rahmens für unterschiedliche Anwendungsfälle bedarf es deshalb nicht. Gleiches gilt für die gemäß der Erfindung weiterhin vorgesehenen Kontaktschienen, die einerseits als Leiter des Stromes, der über die mit Halbleiter-Chips bestückten Substrate fließt, und andererseits als kraftübertragende Elemente dienen. Durch die Vorgabe der Anordnung über die Zentrierelemente, die nach einem anderen Merkmal der Erfindung in der Grundplatte vorgesehene Schraubbolzen sind, wird eine zuverlässige Führung der Einzelteile beim Herstellungsvorgang bewirkt.

Sie ist dadurch gekennzeichnet, daß an aneinander gegenüberliegenden Seiten des Rahmens Gegenschienen mit Ausnehmungen für die als Kontaktschienen ausgebildeten Druckelemente vorgesehen sind, und daß die Gegenschienen auf den Zentrierelementen angeordnet sind. Diese erfindungsgemäße Ausbildung definiert eindeutig zum einen die Anordnung dieser Gegenschienen, da sie - mit den entsprechenden Ausnehmungen versehen - einfach auf die Zentrierelemente aufgesteckt werden. Die Gegenschienen ihrerseits weisen Ausnehmungen zur Lagerung der dann senkrecht zu ihnen in der Grundplattenhauptebene anzuordnenden Kontaktschienen auf. Sämtliche der genannten Teile sind so aufeinander abgestimmt, daß es zu einer einwandfreien Kontaktierung der Leistungshalbleiter-Chips durch die eingelegten Kontaktschienen mit ihren Kontaktschnüren kommt.

In Fortführung des Grundgedankens der Erfindung wird die Kontaktierung der Chips sowie die gesamte Herstellung des erfindungsgemäßen Leistungshalbleiter-Moduls verbessert, wenn auf den Zentrierelementen und den Kontakt- sowie den Gegenschienen Druckbügel vorgesehen sind. Die Druckbügel können in etwa in Länge und Breite mit den Gegenschienen übereinstimmen. Durch Aufschrauben von Muttern auf die als Zentrierelemente eingesetzten Schraub- oder Gewindebolzen können somit die Kontaktschienen mit dem erforderlichen Kontaktdruck über die Druckbügel beaufschlagt werden.

Eine weitere vorteilhafte Ausgestaltung des Grundgedankens der Erfindung besteht darin, daß der Rahmen gitterförmig ausgebildet ist und das Gitter des Rahmens einstückig mit ihm ausgebildete Führungen für Hilfskontakte aufweist. Diese sind somit in einem Arbeitsgang zusammen mit dem Rahmen, insbesondere im Wege des Spritzgießens, herstellbar. In die Führungen sind elektrische Kontakte einführbar, die z.B. eine Verbindung mit einer auf dem erfindungsgemäßen Leistungshalbleiter-Modul angeordneten Leiterplatte herstellen, die ihrerseits eine Schnittstelle zu einem Zusatzaggregat, z.B. einem Steuergerät, bildet.

Weitere Einzelheiten, Merkmale und Vorteile der Erfindung ergeben sich aus der folgenden Beschreibung eines bevorzugten Ausführungsbeispiels sowie anhand der schematischen Zeichnung und der Patentansprüche. Es zeigen:
- Fig. 1 bis 4: die Abfolge des Zusammenbaus wesentlicher Teile eines erfindungsgemäßen Leistungshalbleiter-Moduls in perspektivischer Darstellung und
- Fig. 5: einen Teilschnitt durch den Gegenstand der Fig. 3 gemäß der Schnittebene V-V.

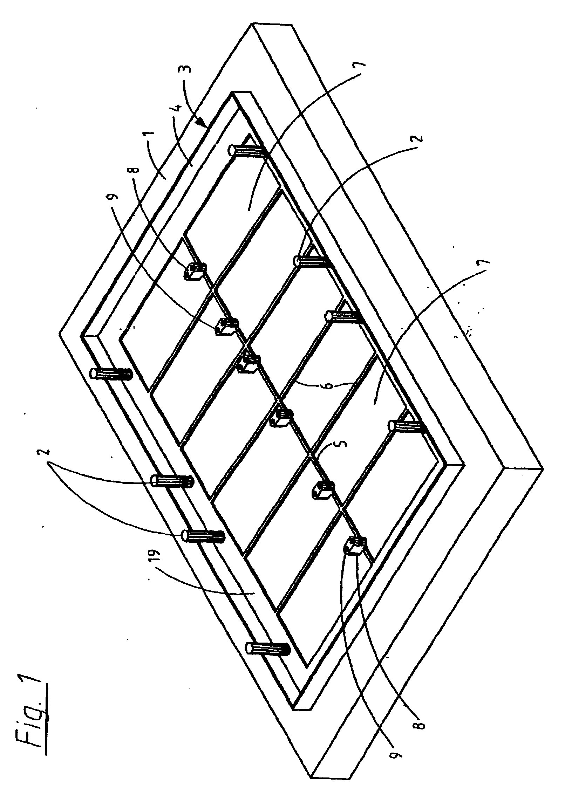

Ein erfindungsgemäßes Leistungshalbleiter-Modul 10 wird im folgenden in der Reihenfolge des Zusammenbaus einer beispielhaften dreiphasigen gesteuerten Brückenschaltung erläutert: Man geht aus von einer Grund- oder Kühlplatte 1 mit Gewindebolzen oder Zentrierelementen 2 nach Fig. 1. Die Grundplatte 1 wird in der Regel gleichzeitig die Grundplatte eines nicht dargestellten Steuergerätes bilden, das weitere, insbesondere elektronische Baugruppen aufnehmen und in fertiggestellter Bauform durch weitere Gehäuseteile verschlossen werden kann. Die typischerweise metallische Grundplatte 1 kann gekühlt werden, z.B. durch Anströmen von nicht gezeigten Kühlrippen mit Luft oder Durchströmen ebenfalls nicht speziell dargestellter integrierter Kanäle mit Kühlflüssigkeit. Bei Bedarf kann auf der Grundplatte 1 im Bereich zwischen den Gewindebolzen 2 ein den Wärmeübergang zu den in einem späteren Montageschritt anzupressenden Substraten verbesserndes Medium - z.B. Wärmeleitpaste - aufgetragen werden.

Fig. 1 zeigt weiterhin einen auf die Grundplatte 1 aufgesetzten Rahmen oder Gehäuserahmen 3. Er wird, wie unten erläutert, im montierten Zustand des Leistungshalbleiter-Moduls an die Grundplatte 1 angepreßt. Er dient zum Schutz der Leistungshalbleiter-Chips, indem er die auf diese aufgebrachten Vergußmasse am Wegfließen hindert, sowie der Führung von im folgenden aufgeführten Bauteilen während und teilweise nach der Montage. Dies bedeutet, daß an den Gehäuserahmen 3 keine besonderen Anforderungen hinsichtlich der Aufnahme von Kräften bestehen, so daß er als kostengünstiges dünnwandiges Kunststoffteil, z.B. aus einem Duroplast, ausgeführt werden kann.

Wie sich ebenfalls u.a. aus Fig. 1 ergibt, weist der Rahmen 3 einen umlaufenden Randteil 4 aus einem rechtwinkligen Winkelprofil auf; weiterhin einen Längssteg 5 und Querstege 6, die ein Gitter bilden, welches einzelne Felder 7 definiert. Am Längssteg 5 sind einstückig mit ihm ausgebildete Führungen 8 für Hilfskontakte vorgesehen. Sie weisen Ausnehmungen 9 auf, in die diese Hilfskontakte eingeführt werden, die z.B. zur Übertragung von Steuersignalen zu einer auf dem Modul noch vorzusehenden Leiterplatte (nicht gezeigt) dienen. Der Rahmen 3 weist an seinem auf der Grundplatte 1 aufliegenden Schenkel 19, der rechtwinklig zum Randteil 4 vorgesehen ist, zu den Zentrierelemente 2 korrespondierende Öffnungen auf, so daß er auf die Grundplatte 1 aufgelegt werden kann und dort in der Ebene der Grundplatte 1 festgelegt ist.

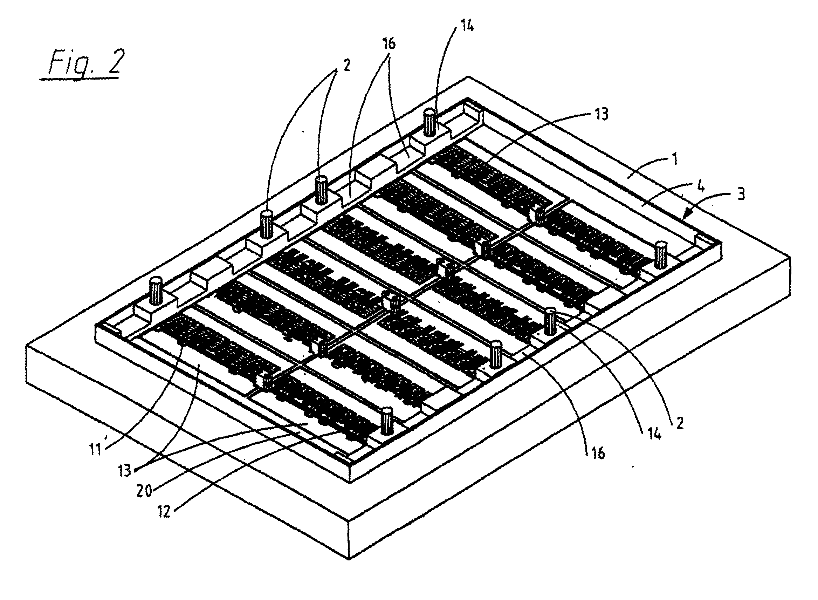

In Fig. 2 ist gezeigt, wie Substrate 13 in die Felder 7 des Gehäuserahmens 3 eingelegt sind. Es handelt sich um DCB-Substrate, wie bekannt, auf denen die Leistungshalbleiter-Chips angeordnet sind. Man erkennt, daß die Möglichkeit besteht, Substrate 13 mit verschiedenen Chipbestückungen - dargestellt sind größere Chips 11 und kleinere Chips 12 - ohne weitere konstruktive Änderungen am Aufbau des Rahmens 3 zu verwenden. Hohe Effizienz des Fertigungsvorgangs wird erreicht, indem identische Substrate für alle Schalter verwendet werden. Die belöteten und drahtbondierten Substrate 13 können während ihres Fertigungsprozesses bereits auf Fehler kontrolliert werden, so daß der Einbau defekter Komponenten in das Leistungshalbleiter-Modul 10 auszuschließen ist. Auch können, wie gezeigt, mehrere Substrate 13 parallel geschaltet werden, um einen Leistungsschalter mit höherer Chipzahl, als wirtschaftlich auf einem Substrat realisiert werden kann, aufzubauen: Die gezeigte Anordnung der Dreiphasen-Brücke bestehend aus sechs Schaltern ist mit zwölf Substraten, mithin also deren zwei pro Schalter, realisiert. Die Substrate 13 entsprechen in ihren Abmessungen denen der Felder 7, so daß sie während der Montage durch das Gitter des Rahmens zuverlässig gehaltert sind.

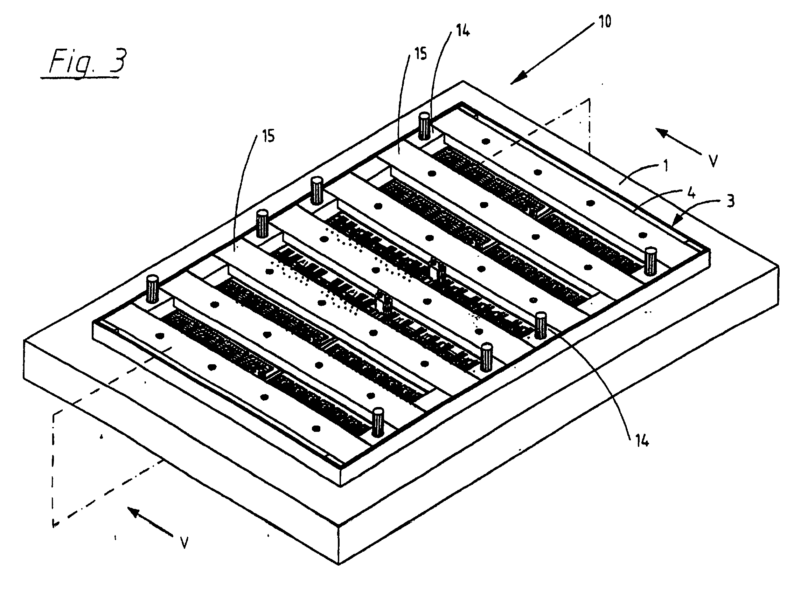

Weiterhin werden, wie besonders in Fig. 2 gezeigt ist, Gegenschienen 14 auf die Gewindebolzen 2 gesteckt. Deren Aufgabe besteht auch in der Führung der im nächsten Montageschritt einzusetzenden Kontaktschienen 15, siehe Fig. 3. Zur Aufnahme der Kontaktschienen 15 und eindeutigen Fixierung sind die Gegenschienen 14 mit Ausnehmungen 16 versehen, deren Querschnitt dem der Kontaktschienen 15 entspricht Beim gezeigten Ausführungsbeispiel sind die Ausnehmungen 16 und die Kontaktschienen 15 so bemessen, daß sie an der Oberkante, also im Bereich des Austritts der Gewindebolzen 2 aus den Gegenschienen, bündig mit der Oberkante des Randteils des Rahmens 3 abschließen.

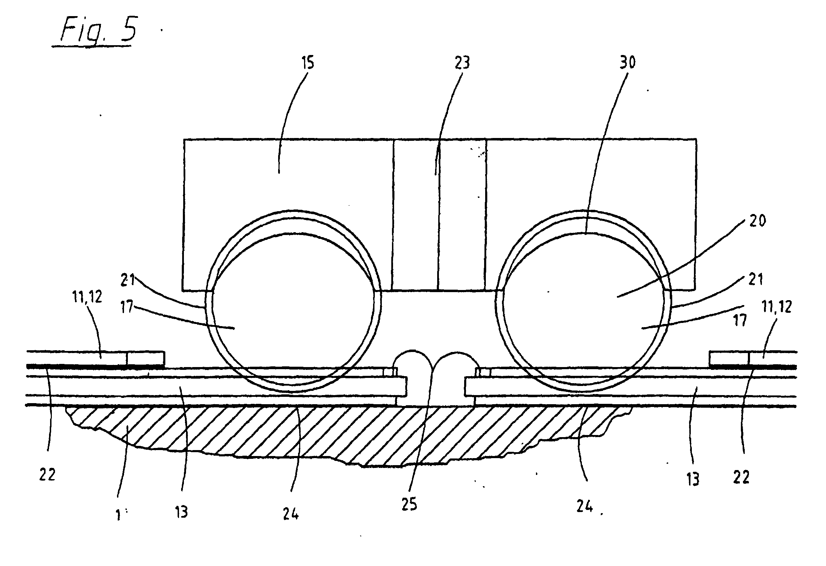

In Fig. 5 ist ein Querschnitt einer Kontaktschiene 15, von Kontaktschnüren 17 sowie der damit kontaktierten Substrate 13 dargestellt. Ziel beim Andrücken der Substrate 13 mittels dieses Aufbaus ist einerseits der elektrische Anschluß, andererseits der möglichst flächige Andruck der Substrate 13 an die wärmeableitende Grundplatte 1 zur thermischen Kopplung. Vorteilhaft ausgeführte Kontaktschnüre bestehen aus einem Kern 20 aus elastischem Material, z.B. Silikongummi, der von einer leitfähigen und flexiblen, jedoch nicht notwendigerweise elastischen Umhüllung 21 umgeben ist, z.B. Kupferdrahtgeflecht. Auf diese Weise erreicht man eine Entkopplung der Funktionen flächiger Druck - der von dem insbesondere hinreichend hitzebeständigen Elastomerkern aufgebracht wird -, und elektrische Kontaktierung, die mit möglichst geringem Widerstand sowie hoher Lebensdauer auch bei thermisch-mechanischen Zyklen ausgeführt ist.

In Fig. 5 ist die Kontaktschnur 17 mit ihrer Umhüllung 21 im unkomprimierten Zustand zwischen der Kontaktschiene 15 und dem Substrat 13 eingezeichnet, um die bei Endmontage entstehende Kompression der in der Darstellung überlappenden Bereiche anzudeuten. Tatsächlich liegen im montierten Zustand die Kontaktschnüre 17 an dem Profil 30 der Kontaktschienen 15 an sowie flach auf Eine mögliche längerfristige Beeinträchtigung der Chips 11, 12 durch Verunreinigung des später einzubringenden Vergusses durch das Material der Kontaktschnüre 17 kann ausgeschlossen werden, wenn man hierfür ein ElastomerMaterial, z.B. auf Silikon-Basis, wie Silikongummi, wählt.

Wie sich aus Fig. 5 weiter ergibt, sind die Chips 11, 12 über eine Lotschicht 22 mit dem Substrat 13 verbunden, das eine elektrische leitfähige Kupferschicht 25 aufweist Die Schicht 24 gibt eine Wärmeleitpaste 24 wieder, die zwischen Substrat 13 und der Grund- oder Kühlplatte 1 vorhanden ist.

Vorzugsweise sind zwei Kontaktschnüre 17 pro Kontaktschiene 15 vorhanden. Sie erstrecken sich im wesentlichen über die Länge der Kontaktschienen 15, in denen weitere Ausnehmungen 23 vorgesehen sind. Sie können zur Befestigung einer das erfindungsgemäße Leistungshalbleiter-Modul abdeckenden Leiterplatte herangezogen werden.

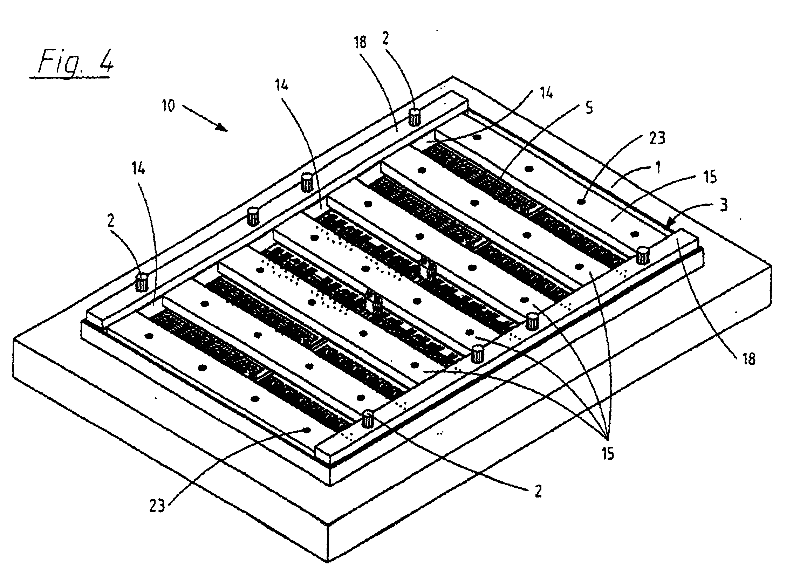

Vorteilhaft beim erfindungsgemäßen Aufbau wirkt sich ferner die erwähnte Führung der Kontaktschienen 15 in den Gegenschienen 14 aus. Wenn Druckbügel 18 auf die Gewindebolzen 2 gelegt werden, wie in Fig. 4 dargestellt, so ergibt sich durch das Zusammenpressen von Druckbügel 18 und Gegenschienen 14 auf Anschlag mittels auf die Gewindebolzen 2 aufgeschraubter Muttern ein konstanter Anpreßdruck unabhängig vom genauen Drehmoment beim Festschrauben, was die Varianz relevanter Produkteigenschaften wie elektrische und thermische Kopplung der Leistungshalbleiter minimiert.

Die in Fig. 3 und Fig. 4 gezeigten Gate-Kontaktfedern dienen dem elektrischen Anschluß von bei steuerbaren Schaltern benötigten Ansteuerpotentialen. Sie werden nicht mit größeren Strömen belastet. Zu ihrer Aufnahme sind mechanische Führungen 8 im Gehäuserahmen vorgesehen, die ein seitliches Wegrutschen verhindern, ansonsten aber keine mechanischen Kräfte aufnehmen.

Auf den in Fig. 4 gezeigten Aufbau des Leistungshalbleiter-Moduls 10 kann in nun folgenden Montageschritten des Steuergerätes in einfacher Weise beispielsweise eine Leiterplatte befestigt werden, was typischerweise durch Anschrauben unter Verwendung der Ausnehmungen 23, die als Gewindebohrungen ausgeführt sein können, geschieht. Diese Leiterplatte kann auf ihrer den Kontaktschienen zugewandten Seite Kontaktflächen aufweisen, die die Kontaktschienen auf ihrer in Fig. 4 sichtbaren Oberfläche, die die Ausnehmungen 23 enthält, durch den Druck des Anschraubens flächig und damit mit hoher Stromtragfähigkeit kontaktieren. Auf der Leiterplatte können beispielsweise zwischen dem positiven und negativen elektrischen Potential des Zwischenkreises Kondensatoren angeordnet sein, wie sie typischerweise bei Spannungszwischenkreisumrichtern eingesetzt werden. Der erfindungsgemäße Aufbau weist hierbei den besonderen Vorteil auf, daß sich die Kondensatoren in unmittelbarer räumlicher Nähe der Halbleiter- Chips befinden, was als niederinduktiver Aufbau insbesondere zur Optimierung des Schaltverhaltens der Halbleiter- Chips beiträgt. Der äußere Anschluß des Leistungshalbleiter- Moduls, beispielsweise zur externen Spannungsversorgung sowie dem Verbraucher, typischerweise einer elektrischen Maschine, kann analog zur Befestigung der Leiterplatte unter Verwendung der bereits erwähnten Schraubverbindungen, die die Ausnehmungen 23 nutzen, erfolgen. Die Ansteuerpotentiale werden wie erwähnt mittels Kontaktfedern von den Substraten 13 abgenommen. Befestigt man in der beschriebenen Weise eine Leiterplatte auf dem Leistungshalbleiter- Modul, so können diese Kontaktfedern die Ansteuerpotentiale auf an entsprechenden Stellen auf der Leiterplatte angeordnete metallisierte Felder übertragen. Diese Kontaktierung erfolgt ohne zusätzliche Arbeitsgänge während der beschriebenen Anbringung der Leiterplatte. Die Kontaktierung mittels Federn ist für die Ansteuerpotentiale als ausreichend zu erachten, da die fließenden Ströme im Vergleich zum Leistungskreis, der wie erläutert über die Kontaktschienen angeschlossen wird, klein sind. Auf der Leiterplatte wird man die Gate- Treiber anordnen, welche sich somit wiederum in unmittelbarer Nähe der Halbleiter-Chips befinden. Dies ist sowohl montagetechnisch als auch hinsichtlich des elektrischen Verhaltens vorteilhaft. Die Anordnung der einzelnen im vorigen beschriebenen Komponenten ergibt sich aus der Anschlußfolge des erfindungsgemäßen Leistungshalbleiter- Moduls, nämlich im in Fig. 4 dargestellten Fall L₊, G₁, L₁, G₂, L₋, G₄, L₂, G₃, L₊, G₅, L₃, G₆, L₋, wenn man das übliche Bezeichnungsschema für dreiphasige gesteuerte Brücken zugrunde legt. Die Druckbügel 18 können als führende Montagehilfe bei Montage der Leiterplatte dienen. Als Maßnahme zur zusätzlichen Qualitätsverbesserung und Kostensenkung läßt sich ein solchermaßen montiertes Leistungshalbleiter-Modul 10 bereits vollständig testen, so daß im Bedarfsfalle noch Komponenten, insbesondere Substrate 13, ausgewechselt werden können. Andernfalls wird man mit teilweisem oder vollständigen Vergießen des Leistungshalbleitermoduls 10 und Montage der weiteren Komponenten des Steuergerätes fortfahren, dessen Teil es bilden kann.

Neben dem Rahmen 3 können auch die Gegenschienen 14 und Druckbügel 18 aus preiswerten Duroplasten hergestellt werden.

## Patentansprüche

1. Leistungshalbleiter-Modul (10) mit einer Grundplatte (1), auf der mindestens ein mit Leistungshalbleiter-Chips (11, 12) bestücktes Substrat (13) angeordnet ist, das über Druckelemente an die Grundplatte (1) andrückbar ist, wobei die Druckelemente elastische und leitfähige Anschlußelemente (17) aufweisen, welche zwischen Kontaktschienen (15) und den Substraten (13) angeordnet sind,
**dadurch gekennzeichnet, dass** die Anschlußelemente Kontaktschnüre (17) sind, die einen elastischen Kern (20) und eine elektrisch leitfähige Umhüllung (21) aufweisen.

2. Leistungshalbleiter-Modul nach Anspruch 1,
**dadurch gekennzeichnet, dass** die Kontaktschienen (15) an einer die Kontaktschnüre (17) kontaktierenden Fläche mit einem diesen angepaßten Profil versehen sind.

3. Leistungshalbleitermodul nach mindestens einem der vorhergehenden Ansprüche,
**dadurch gekennzeichnet, dass** auf der Grundplatte (1) ein Felder (7) definierender Rahmen (3) mittels Zentrierelementen (2) fixierbar ist, wobei mindestens ein Teil der Felder (7) korrespondierende Substrate (13), die mit Leistungshalbleiter-Chips (11, 12) bestückt sind, aufnimmt.

4. Leistungshalbleitermodul nach mindestens einem der vorhergehenden Ansprüche,
**dadurch gekennzeichnet, dass** an einander gegenüberliegenden Seiten des Rahmens (3) Gegenschienen (14) mit Ausnehmungen (16) für die als Kontaktschienen (15) ausgebildeten Druckelemente vorgesehen sind, und dass die Gegenschienen (14) auf den Zentrierelementen (2) angeordnet sind.

5. Leistungshalbleitermodul nach mindestens einem der vorhergehenden Ansprüche,
**dadurch gekennzeichnet, dass** die Zentrierelemente Gewindebolzen (2) sind.

6. Leistungshalbleitermodul nach mindestens einem der vorhergehenden Ansprüche,
**dadurch gekennzeichnet, dass** das Gitter des Rahmens (3) einstückig mit ihm ausgebildete Führungen (8) für Hilfskontakte aufweist, wobei die Hilfskontakte elektrische Verbindungen zu mindestens einer auf den Kontaktschienen (15) angebrachten Leiterplatte herstellen.

7. Leistungshalbleitermodul nach mindestens einem der vorhergehenden Ansprüche,
**dadurch gekennzeichnet, dass** auf den Gegenschienen (14) Druckbügel (18) vorgesehen sind, die die Kontaktschienen (15) niederhalten und über die Zentrierelemente (2) geführt werden.

8. Leistungshalbleitermodul nach mindestens einem der vorhergehenden Ansprüche,
**dadurch gekennzeichnet, dass** der Rahmen (3) gitterförmig ausgebildet und mit hochgezogenen Seiten versehen ist.

9. Leistungshalbleitermodul nach mindestens einem der vorhergehenden Ansprüche,
**dadurch gekennzeichnet, dass** die Kontaktschienen (15) Einrichtungen, wie Gewindebohrungen (23), aufweisen zum Anschluß der den Laststrom führenden äußeren elektrischen Verbindungen des Leistungshalbleiter-Moduls sowie zur flächigen Kontaktierung mindestens einer Leiterplatte, die mit Bauelementen des Leistungsteils bestückt ist.

## Claims

1. A power semiconductor module (10) having a base plate (1) on which is arranged at least one substrate (13) provided with power semiconductor chips (11, 12) and which may be pressed on to the base plate (1) by means of pressure elements having elastic and conductive connector elements (17) arranged between contact bars (15) and the substrates (13),
**characterised in that** the connector elements are contact cords (17) which have an elastic core (20) and an electrically conductive sheath (21).

2. A power semiconductor module according to Claim 1,
**characterised in that**, on a surface contacting the contact cords (17), the contact bars (15) are provided with a profile matching the said contact cords.

3. A power semiconductor module according to at least one of the preceding claims,
**characterised in that** a frame (3) defining fields (7) is fixable on the base plate (1) by means of centring elements (2), at least some of the fields (7) accommodating corresponding substrates (13) provided with power semiconductor chips (11, 12).

4. A power semiconductor module according to at least one of the preceding claims,
**characterised in that** opposing bars (14) on opposite sides of the frame (3) are provided with recesses (16) for the pressure elements in the form of contact bars (15), and **in that** the opposing bars (14) are arranged on the centring elements (2).

5. A power semiconductor module according to at least one of the preceding claims,
**characterised in that** the centring elements are threaded bolts (2).

6. A power semiconductor module according to at least one of the preceding claims,
**characterised in that** the grid of the frame (3) has guide members (8) integrally formed therewith for auxiliary contacts, the auxiliary contacts forming electrical connections to at least one printed circuit board mounted on the contact bars (15).

7. A power semiconductor module according to at least one of the preceding claims,
**characterised in that** pressure clamps (18) are provided on the opposing bars (14), the pressure clamps hold down the contact bars (15) and are guided via the centring elements (2).

8. A power semiconductor module according to at least one of the preceding claims, **characterised in that** the frame (3) is designed in the form of a grid and is provided with raised sides.

9. A power semiconductor module according to at least one of the preceding claims,
**characterised in that** the contact bars (15) have devices such as threaded bores (23) for connecting the external electrical connections of the power semiconductor module which conduct the load current, and for the planar contacting of at least one printed circuit board which has been provided with components of the power section.

## Revendications

1. Module semi-conducteur de puissance (10) avec une plaque de base (1), sur laquelle est disposé au moins un substrat (13) qui est équipé de puces semi-conductrices de puissance (11, 12) et qui peut être appliqué par pression contre la plaque de base (1) au moyen d'éléments de pression, dans lequel les éléments de pression présentent des éléments de connexion élastiques et conducteurs (17) qui sont disposés entre des barres de contact (15) et les substrats (13), **caractérisé en ce que** les éléments de connexion sont des fils de contact (17) qui présentent une âme élastique (20) et une gaine (21) conduisant l'électricité.

2. Module semi-conducteur de puissance selon la revendication 1, **caractérisé en ce que** les barres de contact (15) sont pourvues en une surface contactant les fils de contact (17) d'un profil adapté à ceux-ci.

3. Module semi-conducteur de puissance selon au moins une des revendications précédentes, **caractérisé en ce qu'**un cadre (3) définissant des champs (7) peut être fixé sur la plaque de base (1) au moyen d'éléments de centrage (2), dans lequel au moins une partie des champs (7) reçoit des substrats correspondants (13) qui sont équipés de puces semi-conductrices de puissance (11, 12).

4. Module semi-conducteur de puissance selon au moins une des revendications précédentes, **caractérisé en ce que**, sur des côtés opposés l'un à l'autre du cadre (3) sont prévues des contre-barres (14) ayant des évidements (16) destinés aux éléments de pression conçus sous forme de barres de contact (15), et **en ce que** les contre-barres (14) sont disposées sur des éléments de centrage (2).

5. Module semi-conducteur de puissance selon au moins une des revendications précédentes, **caractérisé en ce que** les éléments de centrage sont des boulons filetés (2) .

6. Module semi-conducteur de puissance selon au moins une des revendications précédentes, **caractérisé en ce que** la grille du cadre (3) présente des guides (8) formés d'une seule pièce avec elle destinés à des contacts auxiliaires, dans lequel les contacts auxiliaires réalisent des liaisons électriques à au moins une plaquette de circuit imprimé disposée sur les barres de contact (15).

7. Module semi-conducteur de puissance selon au moins une des revendications précédentes, **caractérisé en ce que** sont prévus sur les contre-barres (14) des étriers de serrage (18) qui maintiennent les barres de contact (15) et sont positionnés grâce aux éléments de centrage (2).

8. Module semi-conducteur de puissance selon au moins une des revendications précédentes, **caractérisé en ce que** le cadre (3) est conçu sous forme d'une grille et pourvu de côtés surélevés.

9. Module semi-conducteur de puissance selon au moins une des revendications précédentes, **caractérisé en ce que** les barres de contact (15) présentent des dispositifs, comme des trous taraudés (23), destinés à connecter les liaisons électriques externes du module semi-conducteur de puissance parcourues par le courant de charge ainsi qu'à fournir une surface de contact pour au moins une plaquette de circuit imprimé qui est équipée de composants de la partie de puissance.
